Europäisches Patentamt

European Patent Office

Office européen des brevets

(19)

(11) Veröffentlichungsnummer : **0 457 769 B1**

(12)           **EUROPÄISCHE PATENTSCHRIFT**

(45) Veröffentlichungstag der Patentschrift :
    **16.06.93 Patentblatt 93/24**

(51) Int. Cl.⁵ : **G01R 31/318, G06F 11/26**

(21) Anmeldenummer : **90901748.5**

(22) Anmeldetag : **23.01.90**

(86) Internationale Anmeldenummer :
    **PCT/DE90/00040**

(87) Internationale Veröffentlichungsnummer :
    **WO 90/08964 09.08.90 Gazette 90/19**

(54) **VERFAHREN ZUR ERZEUGUNG VON TESTMUSTERN FÜR EINEN BAUSTEIN.**

(30) Priorität : **31.01.89 DE 3902835**

(43) Veröffentlichungstag der Anmeldung :
    **27.11.91 Patentblatt 91/48**

(45) Bekanntmachung des Hinweises auf die
    Patenterteilung :
    **16.06.93 Patentblatt 93/24**

(84) Benannte Vertragsstaaten :
    **BE DE FR GB IT NL**

(56) Entgegenhaltungen :
    **GB-A- 2 174 521**
    **IEEE Transactions on Circuits and Systems,**
    **Volume CAS-28, No. 11, November 1981 IEEE**
    **(New York, US), E.J. McCluskey et al.: "Design**
    **for autonomous test", pages 1070-1079**

(73) Patentinhaber : **SIEMENS**
    **AKTIENGESELLSCHAFT**
    **Wittelsbacherplatz 2**
    **W-8000 München 2 (DE)**

(72) Erfinder : **GLUNZ, Wolfgang**
    **Joseph-Maria-Lutz-Anger 16**
    **W-8000 München 83 (DE)**
    Erfinder : **ROTH, Wolfram**
    **Sedlmayerstra e 16**
    **W-8000 München 19 (DE)**
    Erfinder : **JOHANSSON, Mats**
    **Bruneckerstra e 6**
    **W-8000 München 70 (DE)**

## Beschreibung

Die Erfindung bezieht sich auf ein Verfahren zur Erzeugung von Testmustern für einen Baustein, auf dem zu prüfende Module angeordnet sind, deren Anschlußelemente über Netzwerke mit Anschlußelementen des Bausteins verbunden sind.

Die Überprüfung von Halbleiterbausteinen (Chips) erfolgt bekanntermaßen mit Hilfe von Testmustern, die für jeden Baustein entwickelt werden. Aus den Testmustern werden den Eingängen des Bausteins Prüfsignale zugeführt und dann die vom Baustein an den Ausgängen abgegebenen Antwortsignale mit Sollwerten verglichen. Dieser Vergleich ergibt, ob der Baustein die über die Testmuster erfaßbaren Fehler aufweist oder nicht aufweist.

Durch die zunehmende Integration wird das Prüfen von Halbleiterbausteinen immer schwieriger. Zudem wird die Feststellung der Fehlerstelle immer komplizierter. Bei solchen Bausteinen ist es nicht mehr möglich, zum Beispiel mit einer Prüfspitze einzelne Schaltungen, im folgenden Module genannt, im Inneren des Bausteins zu überprüfen.

Diese bekannten Prüfmethoden sind zum Beispiel in IEEE Transactions on Circuits and Systems, Band CAS-28, Nr. 11, November 1981, Seiten 1070 - 1079 beschrieben. Dort wird vorgeschlagen, die Prüfung dadurch zu vereinfachen, daß das auf einem Baustein angeordnete Netzwerk in geeigneter Weise in Teilnetzwerke so aufgeteilt wird, daß die zur Prüfung dieser Teilnetzwerke erforderliche Anzahl von Eingängen des Bausteins kleiner ist als es beim Test des Gesamtbausteins der Fall wäre. Voraussetzung dieser Methode ist aber, daß das Netzwerk in dieser Weise unterteilbar ist.

Das Erstellen von Testmustern für hochintegrierte Halbleiterbausteine erfordert also einen großen Aufwand. Es wäre viel einfacher, wenn die Testmuster für die auf den Halbleiterbausteinen angeordneten Module erzeugt bzw. bereits für die Module vorhandene Testmuster verwendet werden könnten. Dann wäre es aber erforderlich, diese Testmuster für die Module, im folgenden Modultestmuster genannt, so in Testmuster für den Baustein umzuwandeln, im folgenden Bausteintestmuster genannt, daß beim Anlegen dieser Bausteintestmuster die den einzelnen Modulen zugeordneten Modultestmuster an den Moduleingängen anliegen würden bzw. aus den am Baustein abgegebenen Testsignalen die an den Ausgängen der Module abgegebenen Testsignale erzeugt werden könnten. Dabei ist zu berücksichtigen, daß zwischen den Eingängen und Ausgängen der Module und den Eingängen und Ausgängen des Bausteins Netzwerke angeordnet sind, über die eine Verbindung von Eingang bzw. Ausgang des Bausteins und Eingang bzw. Ausgang des Moduls hergestellt wird. Im folgenden werden die Eingänge und Ausgänge des Bausteins bzw. der Module mit Anschlußelementen bezeichnet.

Die der Erfindung zugrundeliegende Aufgabe besteht darin, ein Verfahren zur Erzeugung von Testmustern für einen Baustein anzugeben, nach dem es möglich ist, zum Prüfen von Bausteinen die Modultestmuster zu verwenden. Die Lösung dieser Aufgabe erfolgt mit Hilfe der im Anspruch 1 angegebenen Schritte.

Es müssen somit für jedes auf den Baustein angeordnete und zu prüfende Modul Modultestmuster erzeugt werden oder vorhandene Testmuster verwendet werden. Um die Modultestmuster zur Prüfung verwenden zu können, werden die Verbindungswege durch die zwischen den Eingangsanschlußelementen des Bausteins und den Eingangsanschlußelementen der Module liegenden Netzwerke mit Hilfe von Eingangsübertragungsfunktionen definiert. Entsprechendes gilt für die Verbindungswege über Netzwerke, die zwischen den Ausgangselementen der Module und den Ausgangselementen des Bausteins liegen. Mit Hilfe der Übertragungsfunktionen werden dann die Bausteintestmuster aus den Modultestmustern erzeugt.

Als Module werden definierte Zellen, Makrozellen, wie z.B. Multiplizierer, Addierer usw., verwendet. Die Module können kombinatorischer Natur sein und keine speichernde Elemente enthalten oder Module mit speichernden Elementen, wie Flipflops oder Latches sein.

Die zwischen den Anschlußelementen des Bausteins und den Anschlußelementen der Module liegenden Netzwerke bestehen aus Leitungen und in den Leitungen liegenden Schaltungsgliedern, Multiplexer, Register, die die Signale logisch nicht verfälschen.

In manchen Prüffällen ist es vorteilhaft, wenn ein Modul als Netzwerk dient, also ein solches Modul nur als Verbindung zu einem anderen Modul verwendet wird. Dann wird für ein solches Modul ebenfalls eine Übertragungsfunktion definiert.

Die die Module umgebenden Netzwerke können ebenfalls Schaltungsteile enthalten, die für sich überprüft werden sollen. Dann werden für diese Schaltungsteile Testmuster erzeugt, die über die die übrigen Netzwerke definierenden Übertragungsfunktionen in Testmuster für den Baustein umgesetzt werden.

Wenn bei einem Prüfvorgang mehrere Module sich nicht gegenseitig beeinflussen, ist es möglich, diese Module parallel zu testen. Diese Möglichkeit kann bereits bei der Erzeugung der Testmuster für den Baustein aus den Testmustern für die Module bzw. Netzwerke berücksichtigt werden.

Anhand von Ausführungsbeispielen wird die Erfindung weiter erläutert. Es zeigen

Figur 1    eine Darstellung des Bausteins,

Figur 2    eine Prinzipdarstellung des Verfahrens,
Figur 3    ein Ablaufdiagramm des Verfahrens,
Figur 4    einen Baustein mit zwei Modulen als Beispiel.

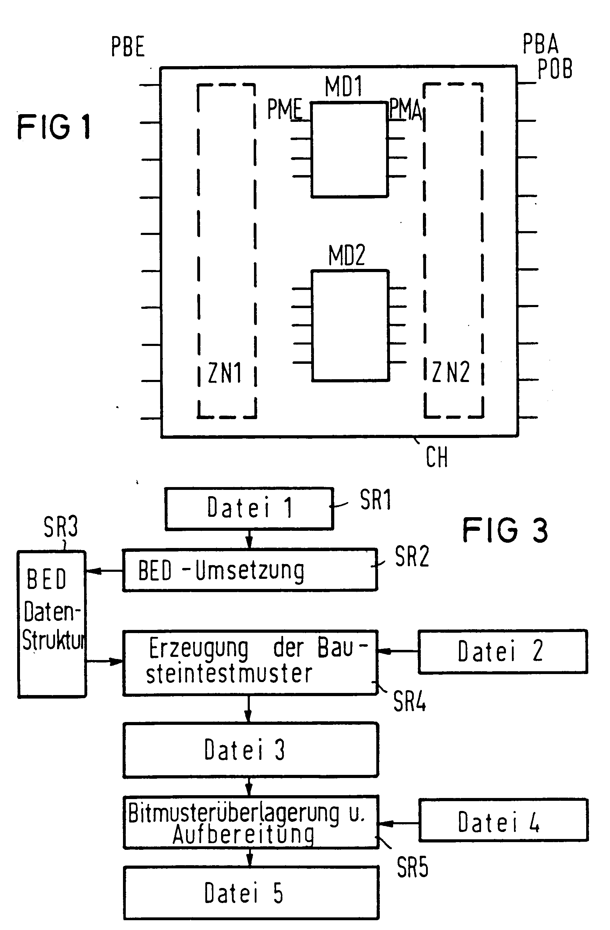

Figur 1 zeigt einen Halbleiterbaustein CH, auf dem nur zwei Module MD1 und MD2 angeordnet sind. Die Module MD1, MD2 können z.B. Addierer, Multiplizierer sein. Sie können kombinatorische Elemente enthalten, aber auch speichernde Elemente. Für diese Module MD1, MD2 sind bereits Testmuster, Modultestmuster, vorhanden oder können auf einfache Weise erzeugt werden. Diese Modultestmuster können jedoch den Modulen nicht zugeführt werden bzw. die von den Modulen abgegebenen Signale können nicht von den Modulen abgenommen werden. Das heißt, es ist nicht möglich, den als Eingang verwendeten Anschlußelementen PME der Module das Testmuster direkt zuzuführen bzw. von den als Ausgängen verwendeten Anschlußelementen PMA die Antwortsignale direkt abzunehmen.

Die Testmuster können nur über Anschlußelemente des Bausteins CH zugeführt bzw. abgenommen werden. Im Beispiel der Figur 1 sind die Anschlußelemente, die als Eingang dienen, mit PBE, die Anschlußelemente, die als Ausgang verwendet werden, mit PBA bezeichnet.

Zwischen den Anschlußelementen PBE, PBA des Bausteins und den Anschlußelementen PME, PMA der Module MD sind Netzwerke ZN angeordnet, z.B. zwischen den als Eingang verwendeten Anschlußelementen PBE des Bausteins und den als Eingang verwendeten Anschlußelementen des Moduls sind Eingangsnetzwerke ZN1 angeordnet. Entsprechend sind zwischen den als Ausgang verwendeten Anschlußelementen PMA der Module und den als Ausgang verwendeten Anschlußelementen PBA des Bausteins Ausgangsnetzwerke ZN2 angeordnet. Über die Netzwerke ZN1 und ZN2 sind dann Verbindungen zwischen den Anschlußelementen des Bausteins und den Anschlußelementen der Module herstellbar. Die Verbindungen werden in Übertragungsfunktionen festgelegt, die beschreiben, wie Signale von den Anschlußelementen des Bausteins zu den Anschlußelementen der Module gebracht werden können und wie die Module an den Anschlußelementen PBA des Bausteins beobachtet werden können.

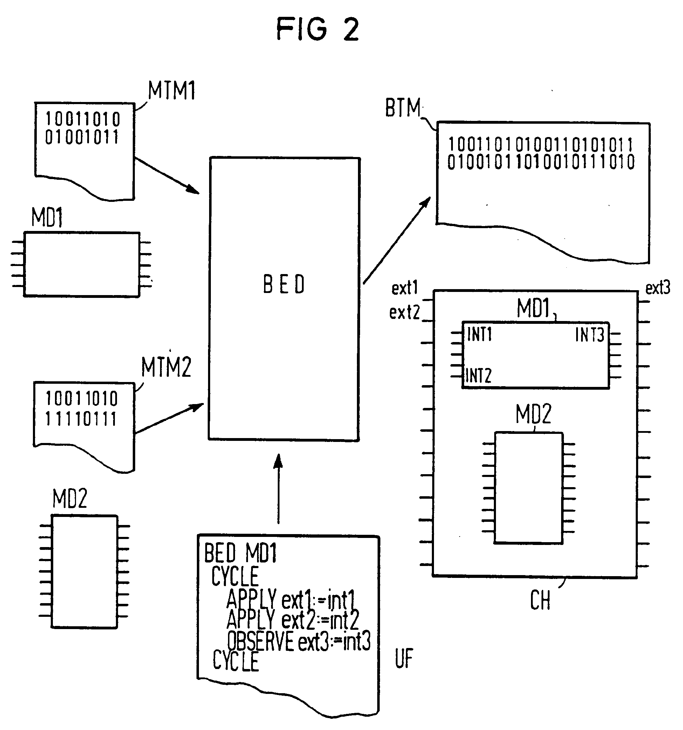

Mit Hilfe von Figur 2 kann dieses Problem deutlicher erläutert werden. Ausgegangen wird von einem Baustein CH mit zwei Modulen MD1 und MD2. Für die Module MD1 und MD2 sind Testmuster MTM1 und MTM2 vorhanden. Diese Testmuster müssen den Modulen MD1 bzw. MD2 an deren Eingängen zugeführt werden und die daraufhin abgegebenen Signale an den Ausgängen dieser Module abgenommen werden und mit Sollwerten verglichen werden.

Das Problem besteht nun darin, daß die Anschlußelemente der Module MD1, MD2 nicht zugänglich sind, zugänglich sind nur die Anschlußelemente des Bausteins CH. Wenn also die Module MD1 und MD2 getestet werden sollen, dann kann dies nur über die Anschlußelemente des Bausteins CH erfolgen. Für den Baustein CH liegen jedoch noch keine Testmuster vor.

Aus den Testmustern MTM der Module MD werden nun die Testmuster für den Baustein erzeugt. Dazu werden Übertragungsfunktionen UF verwendet, die beschreiben, wie jedes Anschlußelement der Module von den Anschlußelementen des Bausteins erreichbar ist. Mit Hilfe der Übertragungsfunktionen UF können dann die Testmuster MTM der Module in Testmuster BTM des Bausteins übersetzt werden. Die Testmuster geben an, welche Bit an den Anschlußelementen des Bausteins CH zugeführt werden müssen, um die an den Anschlußelementen der Module gewünschten Bit zu erzeugen. Dies ist in Figur 2 graphisch dargestellt. Es ist gezeigt, wie aus den Testmustern MTM der Module unter Verwendung der Übertragungsfunktionen UF das Testmuster BTM für den Baustein entsteht.

Die Übertragungsfunktionen UF beinhalten die Zuweisungen von Anschlußelementen der Module zu Anschlußelementen des Bausteins. Ein Ausschnitt aus den Übertragungsfunktionen ist in Figur 2 als BSP bezeichnet. Zum Beispiel kann der Eingang INT1 des Moduls MD1 dem Eingang EXT1 des Bausteins zugewiesen werden oder der Eingang INT2 des Moduls MT1 dem Eingang EXT2 des Bausteins zugewiesen werden. Entsprechend könnte der Ausgang INT3 des Moduls MD1 über den Ausgang EXT3 des Bausteins CH beobachtet werden. Für das Beispiel BSP würde also das Bit, das an EXT1 angelegt wird, auch an INT1 gelangen usw.. Mit diesen Übertragungsfunktionen UF werden nun die Modultestmuster MTM in die Bausteintestmuster BTM umgesetzt (in Fig. 2 mit Block BED bezeichnet).

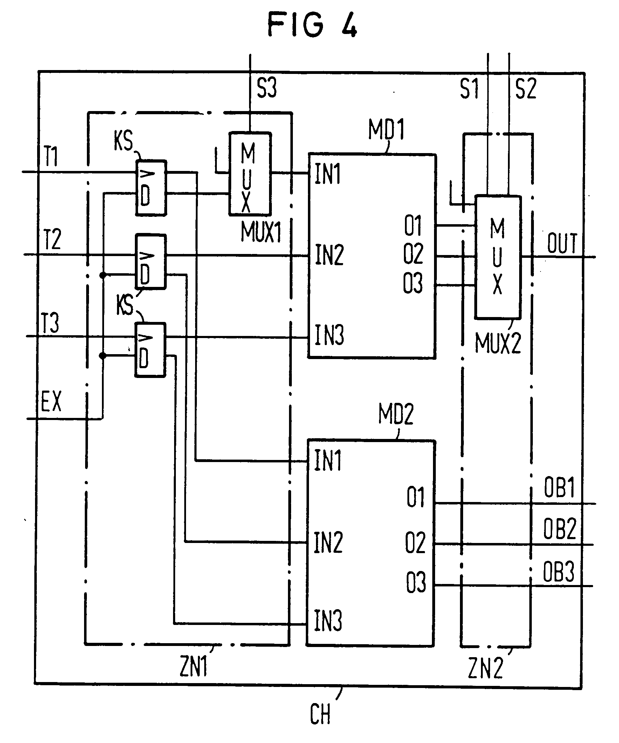

Ein ausführlicheres Beispiel zeigt Figur 4. Hier sind zwei Module MD1 und MD2 als Blöcke dargestellt, die jeweils drei Eingänge IN1 bis IN3 und drei Ausgänge O1 bis O3 aufweisen. Zwischen den Eingängen T1, T2, T3 und EX des Bausteins CH und den Modulen MD liegt ein Eingangsnetzwerk ZN1 bestehend aus bistabilen Kippschaltungen KS und einem Multiplexer MUX1. Die Verschaltung ergibt sich aus Figur 4. Zwischen den Modulen MD1 und den als Ausgängen verwendeten Anschlußelementen des Bausteins ist ein Ausgangsnetzwerk ZN2 angeordnet, das hier nur einen Multiplexer MUX2 enthält. Dit Ausgängt O1 bis O3 des Moduls MD2 sind direkt mit Anschlußelementen des Bausteins verbunden, die mit OB1 bis OB3 bezeichnet sind. Dem Eingangsnetzwerk ZN1 werden Taktsignale t1 bis t3 zugeführt, durch die die Kippschaltungen KS angesteuert werden. Die D Eingänge der Kippschaltungen werden jeweils über den Eingang EX versorgt. Zwischen einer Kippschal-

3

tung KS und dem Eingang IN1 des Moduls MD1 liegt der Multiplexer MUX1, der von einem Steuersignal S3 angesteuert wird. Der Multiplexer MUX2 ist zwischen dem Modul MD1, und zwar dessen Ausgängen O1 bis O3 und dem Ausgang OUT des Bausteins angeordnet und wird von Steuersignalen S1 und S2 angesteuert.

Aus der Tabelle TAB (am Ende der Beschreibung) können die Übertragungsfunktionen entnommen werden, die die Verbindungswege von den Anschlußelementen des Bausteins zu den Modulen MD kennzeichnen. Diese Übertragungsfunktionen sind pro Modul MD angegeben und in Form eines Programms geschrieben. Zunächst werden die Anschlüsse definiert, und zwar die Eingänge und die Ausgänge und die Takte für den Halbleiterbaustein.

Anschließend werden die Anschlüsse des Moduls MD1 und zwar dessen Eingänge und Ausgänge vereinbart. Darauf folgen die Übertragungsfunktionen, die für jedes Testmuster eines Testmustersatzes durchzuführen sind. Es ist zu sehen, daß das Anschlußelement EX des Bausteins invertiert zum Eingang IN1 des Moduls MD1 führt unter der Voraussetzung, daß der Takt t1 binär 1 ist. Der Eingang EX des Bausteins ist mit dem Eingang IN2 des Moduls MD1 verbunden, unter der Voraussetzung, daß das Taktsignal t2 binär 1 ist, usw.. Der Ausgang O1 des Moduls MD1 kann vom Ausgang OUT des Bausteins beobachtet werden, wenn S1 binär 1 und S2 binär 0 ist oder der Ausgang O2 des Moduls MD1 kann vom Ausgang OUT des Bausteins beobachtet werden, wenn das Signal S1 binär 0 und das Signal S2 binär 1 ist, usw..

In der Tabelle sind weiterhin die Übertragungsfunktionen für das Modul MD2 aufgeführt, die entsprechend formuliert sind wie die Übertragungsfunktionen für das Modul MD1.

Mit Hilfe dieser Übertragungsfunktionen ist es somit möglich, aus den Testmustern für die Module MD1 und MD2 Testmuster für den Baustein zu entwickeln, die dann über die Anschlußelemente des Bausteins angelegt werden können. Zum Beispiel wäre das Testmuster für das Modul MD1 für alle Eingänge IN binär 1, dann ergäbe sich folgende Sequenz von Testmustern:

1. Testmuster:    EX = 0, T1 aktiv, S3 = 1 (T2, T3 in Ruhelage)
2. Testmuster:    EX = 1, T2 aktiv, S3 = 1 (T1, T3 in Ruhelage)
3. Testmuster:    EX = 1, T3 aktiv, S3 = 1 (T1, T2 in Ruhelage)

Anhand der Übertragungsfunktionen der Tabelle kann die Transformation von Testmustern für die Module MD in Testmuster für den Baustein sehr leicht nachvollzogen werden. Dabei ist zu berücksichtigen, daß hier Taktsignale t1 bis t3 den Prüfvorgang komplizieren, ein Problem, das zu einer Vervielfachung der Testmuster beim Baustein führt.

Mit Hilfe der Tabelle und der Figur 4 ist erkennbar, daß Fehler der Module MD über Testmuster, die den Anschlußelementen des Bausteins zugeführt werden können, festgestellt werden können. Über die Ausgänge des Bausteins können die einzelnen Ausgänge der Module beobachtet werden, um festzustellen, welche Istwerte dort auftreten, die dann mit den Sollwerten verglichen werden können.

Es kann vorteilhaft sein, wenn in den Netzwerken ZN1 und ZN2 enthaltene Schaltungen ebenfalls überprüft werden können. Beispiel sind die Multiplexer MUX. Dann werden für diese Schaltungen ebenfalls Testmuster erzeugt, z.B. für die Multiplexer MUX, die dann mit Hilfe von Übertragungsfunktionen für das übrige Netzwerk zu den Anschlußelementen des Bausteins transformiert werden.

Bei der Überprüfung von solchen Schaltungen bzw. von hinter andern Modulen liegenden Modulen kann es zweckmäßig sein, daß ein Modul, z.B. MD1 bei der Figur 4, lediglich als Verbindungsweg benutzt wird. Dann müssen für solche Module Übertragungsfunktionen festgelegt werden, die angeben, wie Signale vom Eingang des Moduls zum Ausgang des Moduls gelangen und von dort zu den zu prüfenden Schaltungen bzw. Module. Wenn also der Multiplexer MUX2 mit einem Testmuster geprüft werden sollte, dann müßten dazu Prüfsignale über die Eingänge EX des Bausteins zugeführt werden und die Übertragungsfunktionen über Kippschaltungen KS, Multiplexer MUX1 und Modul MD1 zum Multiplexer MUX2 festgelegt werden und aus diesen Übertragungsfunktionen die an den Anschlußelementen des Bausteins CH anzulegenden Prüfmuster aus dem Prüfmuster für den Multiplexer MUX2 entwickelt werden.

Anhand des Ablaufdiagramms der Figur 3 wird gezeigt, wie die Testmuster für den Baustein aus den Testmustern für die Module und Testmuster für Schaltungen der Netzwerke erzeugt werden. In einen Schritt SR1 werden die Übertragungsfunktionen, und zwar die Eingangs- und die Ausgangsübertragungsfunktionen UF für die einzelnen Module, erzeugt und in einer Datei zusammengefaßt. Aus der Kenntnis der auf dem Chip CH angeordneten Module und den zwischen den Anschlußelementen und der Module liegenden Netzwerke können die Übertragungsfunktionen ermittelt werden. Solche Übertragungsfunktionen sind z.B. in der Tabelle aufgeführt. Die Übertragungsfunktionen werden in Schritten SR2, SR3 durch den Rechner in eine für den Rechner geeignete Datenstruktur umgewandelt. In Dateien 2 sind die Testmuster für die Module enthalten. Diese Testmuster für die Module werden in einem Schritt SR4 mit den Übertragungsfunktionen der Datei 1 verknüpft. Damit ergeben sich die Testmuster für den Baustein CH, die in einer Datei 3 zusammengefaßt sind. Diese Testmuster der Datei 3 können den Anschlußelementen des Bausteins zugeführt werden mit dem Ergebnis, daß die einzelnen Module mit den Testmustern der Datei 2 versorgt werden.

Für den Fall, daß auch Teilschaltungen der Netzwerke ZN1 und ZN2 selbstständig überprüft werden sollen und für diese Teilschaltungen Testmuster vorhanden sind, z.B. in einer Datei 4, werden diese Testmuster mit den Testmustern der Datei 3 überlagert (Schritt SR5) und daraus dann Testmuster für den Baustein entwickelt, mit denen neben den Modulen auch Teilschaltungen getestet werden können. Diese werden dann in der Datei 5 zusammengefaßt.

Für die Erzeugung von Testmustern für den Baustein aus Testmustern für die Module ist es vorteilhaft, wenn die Netzwerke nach bestimmten Entwurfsregeln entwickelt sind. Die Eingänge der Module müssen ja von außen, also von Anschlußelementen des Bausteins, zugänglich sein. Darum ist es zweckmäßig, wenn zwischen den Anschlußelementen des Bausteins und den Anschlußelementen der Module nur ganz bestimmte Schaltelemente enthalten sind, z.B. Treiber, Inverter, Multiplexer, Latches und Flipflops. Diese Schaltelemente haben die Eigenschaft, daß sie anliegende Daten logisch unverfälscht weitergeben. Entsprechendes gilt für die Ausgänge der Module, sie müssen von externen Anschlußelementen des Bausteins beobachtbar sein. Auch hier sind Elemente sinnvoll, welche die Daten logisch nicht verändern. Zudem sollten die Eingänge der Module voneinander unabhängig einstellbar sein. Vorteilhaft ist es auch, wenn die Signale, die die Einstell- und Beobachtungsverbindungen steuern, unabhängig von den Signalen sind, über welche die Bitmuster angelegt bzw. beobachtet werden. Das heißt, die Taktsignale und die Steuersignale für Multiplexer sollten unabhängig sein von den Signalen, die an den Dateneingängen zugeführt werden.

Tabelle

```
CIRCUIT CH
EXTERNAL
  INPUT = EX, S1, S2, S3, T1, T2, T3;
  OUTPUT = OUT, OB1, OB2, OB3;
CLOCK T1, T2, T3 : TP;
BED MD1
EXTERNAL    INPUT IN1, IN2, IN3;
            OUTPUT O1, O2, O3;
INITIALIZE
  CYCLE APPLY s3 : = 1;
FOR ALL MTM1 DO
CYCLE LOOP 1 t1:
  APPLY ex := NOT in1;
CYCLE LOOP 1 t2;
  APPLY ex : = in2;
CYCLE LOOP 1 t3;
  APPLY ex : = in3;
CYCLE
  APPLY s1 : = 1;
  APPLY s2 : = 0;
  OBSERVE out : = o1;
CYCLE
  APPLY s1 : = 0;
  APPLY s2 : = 1;
  OBSERVE out : = o2;
CYCLE
  APPLY s1 : = 1;
  APPLY s2 : = 1;
  OBSERVE out : = o3;
ENDFOR;
ENDBED;
```

```
BED MD2
EXTERNAL    INPUT IN1, IN2, IN3;
            OUTPUT O1, O2, O3;
FOR ALL MTM2 DO
CYCLE LOOP 1 t1;
APPLY ex : = in1;
CYCLE LOOP 1 t2;
APPLY ex : = NOT in2;
CYCLE LOOP 1 t3;
APPLY ex : = NOT in3;
OBSERVE ob1 : = o1;
OBSERVE ob2 : = o2;
OBSERVE ob3 : = o3;
ENDFOR;
ENDBED;

END.
```

## Patentansprüche

1. Verfahren zur Erzeugung von Testmustern für einen Baustein (CH), auf dem zu prüfende Module angeordnet sind, und zur Erzeugung der Antwortsignale an den Modulen, bei dem
   - Verbindungswege zwischen als Eingänge verwendeten Anschlußelementen (PBE) des Bausteins (CH) und als Eingänge verwendeten Anschlußelementen (PME) der Module (MD) über dazwischenliegende Eingangsnetzwerke (ZN1) durch Eingangsübertragungsfunktionen dargestellt werden,
   - Verbindungswege zwischen als Ausgänge verwendeten Anschlußelementen (PMA) der Module (MD) und als Ausgänge verwendeten Anschlußelementen (PBA) des Bausteins (CH) über dazwischenliegende Ausgangsnetzwerke (ZN2) durch Ausgangsübertragungsfunktionen dargestellt werden,
   - aus den Modulen (MD) zugeordneten Modultestmustern (MTM) unter Verwendung der Eingangsübertragungsfunktionen Bausteintestmuster (BTM) für die Eingänge (PBE) des Bausteins derart erzeugt werden, daß bei Anlegen der Bausteintestmuster die den Modulen zugeordneten Modultestmuster am jeweiligen Modul anliegen,
   - aus den an den als Ausgänge verwendeten Anschlußelementen (PBA) des Bausteins (CH) auftretenden Antwortsignalen unter Verwendung der Ausgangsübertragungsfunktionen die an den als Ausgänge verwendeten Anschlußelementen (PMA) der Module (MD) auftretenden Ausgangssignale erzeugt werden.

2. Verfahren nach Anspruch 1,
   bei dem ein Modul (MD) auch als Netzwerk verwendet wird und bei dem die innerhalb des Moduls verlaufenden, die Eingangsanschlußelemente und Ausgangsanschlußelemente des Moduls verbindenden Übertragungswege durch Übertragungsfunktionen dargestellt werden.

3. Verfahren nach Anspruch 2,
   bei dem zur Prüfung von Teilschaltungen der Netzwerke (ZN) Netzwerktestmuster für diese Schaltungsteile erzeugt werden, aus denen unter Verwendung der Übertragungsfunktionen der übrigen Netzwerke und der Module Testmuster für den Baustein erzeugt werden.

**4.** Verfahren nach Anspruch 3,
bei dem die Bausteintestmuster (BTM) von mehreren Modulen oder Netzwerken zusammengefaßt werden, wenn sich Signale auf den Verbindungswegen zu diesen Modulen oder Netzwerken gegenseitig nicht beeinflussen.

**5.** Verfahren nach einem der vorhergehenden Ansprüche,
bei dem die Module (MD) kombinatorische Eigenschaften haben und keine speichernden Elemente enthalten.

**6.** Verfahren nach einem der Ansprüche 1 bis 4,
bei dem die Module speichernde Elemente enthalten.

**7.** Verfahren nach Anspruch 4,
bei dem die die Verbindungswege der Netzwerke oder die Module beschreibenden Übertragungsfunktionen als Daten in einer Datei gespeichert sind.

**8.** Verfahren nach Anspruch 7,
bei dem die die Verbindungswege beschreibenden Übertragungsfunktionen der Netzwerke in einer ersten Datei (Datei 1) zusammengefaßt werden,
bei dem die Modultestmuster in zweiten Dateien (Datei 2) enthalten sind und mit den Übertragungsfunktionen der ersten Datei zu Bausteintestmustern verknüpft werden, die in einer dritten Datei (Datei 3) gespeichert werden.

**9.** Verfahren nach Anspruch 8,
bei dem die Daten der dritten Datei (Datei 3) mit den Netzwerktestmustern aus einer vierten Datei (Datei 4) zu Daten einer fünften Datei (Datei 5) zusammengefaßt werden.

## Claims

**1.** Method for producing test patterns for a chip (CH) on which modules to be tested are arranged, and for producing the reply signals on the modules, in which
   - connecting paths between terminal elements (PBE) of the chip (CH) that are used as inputs and terminal elements (PME) of the modules (MD) that are used as inputs are represented via intervening input networks (ZN1) by input transfer functions,
   - connecting paths between terminal elements (PMA) of the modules (MD) that are used as outputs and terminal elements (PBA) of the chip (CH) that are used as outputs are represented via intervening output networks (ZN2) by output transfer functions,
   - chip test patterns (BTM) for the inputs (PBE) of the chip are produced using the input transfer functions from the module test patterns (MTM) assigned to the modules (MD) in such a way that upon application of the chip test patterns the module test patterns assigned to the modules are present at the respective module,
   - the output signals occurring at the terminal elements (PMA) of the modules (MD) that are used as outputs are produced using the output transfer functions from the reply signals occurring at the terminal elements (PBA) of the chip (CH) that are used as outputs.

**2.** Method according to Claim 1, in which a module (MD) is also used as a network, and in which the transmission paths which extend inside the module and connect the input terminal elements and output terminal elements of the module are represented by transfer functions.

**3.** Method according to Claim 2, in which in order to test subcircuits of the networks (ZN) network test patterns are produced for these circuit parts, from which test patterns are produced for the chip by using the transfer functions of the remaining networks.

**4.** Method according to Claim 3, in which the chip test patterns (BTM) of a plurality of modules or networks are combined when signals on the connecting paths to these modules or networks do not influence one another.

**5.** Method according to one of the preceding claims, in which the modules (MD) have combinatorial properties and contain no storing elements.

6. Method according to one of Claims 1 to 4, in which the modules contain storing elements.

7. Method according to Claim 4, in which the transfer functions that describe the connecting paths of the networks or describe the modules are stored as data in a dataset.

8. Method according to Claim 7, in which the transfer functions of the networks that describe the connecting paths are combined in a first dataset (dataset 1), in which the module test patterns are contained in second datasets (dataset 2) and are combined with the transfer functions of the first dataset to form chip test patterns that are stored in a third dataset (dataset 3).

9. Method according to Claim 8, in which the data of the third dataset (dataset 3) are combined with the network test patterns from a fourth dataset (dataset 4) to form data of a fifth dataset (dataset 5).

## Revendications

1. Procédé pour produire des profils de test pour un composant (CH) sur lequel sont disposés des modules à contrôler, et pour produire les signaux de réponse dans les modules, selon lequel
   - des voies de liaison entre des éléments de raccordement (PBE), utilisés en tant qu'entrées, du composant (CH) et des éléments de raccordement (PME), utilisés en tant qu'entrées, des modules (MD), sont représentés par l'intermédiaire de réseaux intercalaires d'entrée (ZN1) par des fonctions de transfert d'entrée,
   - des voies de liaison entre des éléments de raccordement (PMA), utilisés en tant que sorties, des modules (MD) et des éléments de raccordement (PBA), utilisés en tant que sorties, des composants (CH) sont représentées par des fonctions de transfert de sortie, par l'intermédiaire de réseaux intercalaires de sortie (ZN2),
   - des profils de test de composants (BTM) pour les entrées (PBE) du composant sont produits à partir des profils de test de modules (MTM), associés aux modules (MD), moyennant l'utilisation des fonctions de transfert d'entrée, de telle sorte que lors de l'application des profils de test de composants, les profils de test de modules associés aux modules sont appliqués aux modules respectifs,
   - les signaux de sortie, qui apparaissent dans les composants de raccordement (PMA), utilisés comme sorties, des modules (MD) sont produits à partir des signaux de réponse, qui apparaissent dans les éléments de raccordement (PBA), utilisés comme sorties, du composant (CH), moyennant l'utilisation des fonctions de transfert de sortie.

2. Procédé selon la revendication 1, selon lequel on utilise un module (MD) également en tant que réseau et selon lequel les voies de transmission, qui s'étendent à l'intérieur du module et relient les éléments de raccordement d'entrée des éléments de raccordement de sortie du module, sont représentées par des fonctions de transfert.

3. Procédé selon la revendication 2, selon lequel pour le contrôle de circuits partiels des réseaux (ZN), on produit pour ces éléments de circuit, des profils de test de réseau, à partir desquels des profils de test pour le composant sont produits moyennant l'utilisation des fonctions de transfert des autres réseaux et des modules.

4. Procédé selon la revendication 3, selon lequel les profils de test de composant (BTM) de plusieurs modules ou réseaux sont réunis lorsque des signaux présents dans des voies de liaison reliées à ces modules ou ces réseaux ne s'influencent pas réciproquement.

5. Procédé selon l'une des revendications précédentes, selon lequel les modules (MD) possèdent des propriétés combinatoires et ne comportent aucun élément de mémoire.

6. Procédé selon l'une des revendications 1 à 4, selon lequel les modules comportent des éléments de mémoire.

7. Procédé selon la revendication 4, selon lequel les fonctions de transfert, qui décrivent les voies de liaison des réseaux ou des modules, sont mémorisées en tant que données dans un fichier.

8. Procédé selon la revendication 7, selon lequel les fonctions de transfert, qui décrivent les voies de liaison, des réseaux sont réunies dans un premier fichier (fichier 1), et
les profils de test de modules sont contenus dans des seconds fichiers (fichier 2) et sont combinés aux fonctions de transfert des premiers fichiers pour former des profils de test de composants, qui sont mémorisés dans un troisième fichier (fichier 3).

9. Procédé selon la revendication 8, selon lequel les données du troisième fichier (fichier 3) sont réunies aux profils de test du réseau tirés d'un quatrième fichier (fichier 4) pour former des données d'un cinquième fichier (fichier 5).

FIG 1

FIG 3

# FIG 2

# FIG 4